# EUROPEAN PATENT SPECIFICATION

(11) **EP 1 717 341 B1**
(45) Date of publication and mention of the grant of the patent: **15.04.2015**
(21) Application number: 05709393.2
(22) Date of filing: 27.01.2005
(51) Int. Cl.: C23C 16/40, H01L 31/18, C23C 16/18

(54) **PROCESS FOR PRODUCING TRANSPARENT CONDUCTIVE FILM AND PROCESS FOR PRODUCING TANDEM THIN-FILM PHOTOELECTRIC CONVERTER**
VERFAHREN ZUR HERSTELLUNG EINES TRANSPARENTEN LEITFÄHIGEN FILMS UND VERFAHREN ZUR HERSTELLUNG EINES PHOTOELEKTRISCHEN TANDEM-DÜNNSCHICHT-UMWANDLERS
PROCEDE DE FABRICATION D'UNE PELLICULE CONDUCTRICE TRANSPARENTE ET PROCEDE FABRICATION D'UN CONVERTISSEUR PHOTO LECTRIQUE TANDEM COUCHE MINCE

(30) Priority: 16.02.2004 JP 2004038841
(43) Date of publication of application: 02.11.2006
(73) Proprietor: Kaneka Corporation, Osaka (JP)
(72) Inventor: MEGURO, Tomomi, Ohtsu-shi, Shiga 5200103 (JP); FUKUDA, Susumu, Ohtsu-shi, Shiga 5200026 (JP); YAMAMOTO, Kenji, Kobe-shi, Hyogo 6512277 (JP)
(74) Representative: Vossius & Partner
(86) International application number: PCT/JP2005/001119
(87) International publication number: WO 2005/078154

(56) References cited:
- WO-A-03/065462
- DE-A1- 3 916 983
- JP-A- 3 237 097
- JP-A- 7 235 505
- JP-A- 62 007 123
- JP-A- 2003 347 572
- SU-A1- 1 775 491
- US-A- 4 638 111
- CHI KWAN LAU ET AL: "Growth of epitaxial ZnO thin films by organometallic chemical vapor deposition" JOURNAL OF THE ELECTROCHEMICAL SOCIETY, ELECTROCHEMICAL SOCIETY. MANCHESTER, NEW HAMPSHIRE, US, vol. 127, no. 8, 1 August 1980 (1980-08-01), pages 1843-1847, XP002459232 ISSN: 0013-4651
- LI B S ET AL: "Growth of high quality ZnO thin films at low temperature on Si(100) substrates by plasma enhanced chemical vapor deposition" JOURNAL OF VACUUM SCIENCE AND TECHNOLOGY: PART A, AVS /AIP, MELVILLE, NY, US, vol. 20, no. 1, 1 January 2002 (2002-01-01), pages 265-269, XP012005936 ISSN: 0734-2101
- HAGA K ET AL: "ZnO thin films prepared by remote plasma-enhanced CVD method" JOURNAL OF CRYSTAL GROWTH, ELSEVIER, AMSTERDAM, NL, vol. 214-215, 1 June 2000 (2000-06-01), pages 77-80, XP004200968 ISSN: 0022-0248

## Description

### Technical Field

The present invention relates to a method for making a transparent conductive film which contains zinc oxide as a main component and which has high transmittance, low resistivity, and excellent surface morphology, and a method for making a tandem thin-film photoelectric converter including the method for making the transparent conductive film.

### Background Art

Transparent conductive films have been used for transparent electrodes for various light-receiving devices, such as photoelectric converters, e.g., solar cells, and display devices, such as liquid crystal displays, PDPs, and EL displays, and recently, the importance thereof has been increasing.

Above all, transparent conductive films used for solar cells are required to have high transparency and conductivity, and surface unevenness for effectively utilizing light. Known examples of such transparent conductive films include films made of indium oxide (In₂O₃) to which a small amount of tin has been added (hereinafter, such addition is also referred to as "doping"; and the substance which has been added in a small amount may be referred to as a "dopant"), films made of tin oxide (SnO₂) doped with antimony or fluorine to achieve desired conductivity characteristics, and films made of zinc oxide (ZnO).

. Indium oxide (hereinafter referred to as "ITO") films have high conductivity and have been widely used. However, indium (In), i.e., the raw material, is a rare metal and produced in low volume. Therefore, if the demand for transparent conductive films increases, there will be a difficulty in supplying In stably. Moreover, the reduction in cost is limited because In is expensive. SnO₂ is more inexpensive than ITO, and since SnO₂ has a low free electron concentration, it is possible to obtain films with high transmittance. However, SnO₂ has drawbacks in that it has low conductivity and low plasma durability.

In contrast, zinc is abundantly available and is also inexpensive as a source material. Zinc oxide films have characteristics, such as high plasma durability and high transmittance for long-wavelength light because of high mobility. Therefore, zinc oxide is also suitable for use in transparent conductive films for solar cells, and development of transparent conductive films containing zinc oxide, as an alternative material to ITO or SnO₂, as a main component has been proceeding.

Zinc oxide films are formed mainly by sputtering or CVD. With respect to sputtering, it is relatively difficult to control resistivity, transmittance, and film surface morphology. Furthermore, sputtering systems are expensive, resulting in an increase in manufacturing cost. With respect to CVD, films with high transmittance can be easily obtained, and also film surface morphology can be easily controlled. CVD systems are less expensive than sputtering systems.

Patent Document 1 discloses a method for forming a zinc oxide film using CVD, in which as a dilution gas used during introduction of an organozinc compound or an oxidizing agent into a deposition chamber, Ar, He, or N₂ is used. In the disclosed technique, Ar and He are expensive, resulting in an increase in manufacturing cost.

[Patent Document 1] Japanese Examined Patent Application Publication No. 6-82665

US4638111 deposits ZnO-films by CVD using diethyl zinc, water and diborane with argon as dilution gas.

### Disclosure of Invention

### [Problems to be Solved by the Invention]

The present invention has been achieved to overcome the drawback associated with the prior art in that the dilution gas is expensive. It is an object of the present invention to provide a method for making a transparent conductive film, which contains zinc oxide as a main component and which has high transmittance, low resistivity, and excellent surface morphology, highly uniformly and simply, and it is another object of the present invention to provide a method for making a tandem thin-film photoelectric converter including the method for making the transparent conductive film.

### [Means for Solving the Problems]

According to the present invention, a method for making a transparent conductive film according to claim 1 is provided.

Since hydrogen has high thermal conductivity and is inexpensive, it is possible to provide a transparent conductive film having excellent characteristics with low cost.

The organozinc compound is preferably diethylzinc. Since diethylzinc is highly reactive with the oxidizing agent, the deposition efficiency is improved.

The oxidizing agent is water. Since water is highly diffusible and highly reactive with the organozinc compound, the deposition efficiency is improved.

A Group III element-containing compound is introduced into the deposition chamber so that the transparent conductive film containing zinc oxide as the main component doped with a small amount of the group III element is formed on the substrate. Since a transparent conductive film with low resistivity can be formed, the efficiency of the resulting thin-film photoelectric converter is improved.

In particular, the Group III element-containing compound is more preferably at least one of diborane (B₂H₆) and trimethylaluminum ((CH₃)₃Al). Since the decomposition efficiency of such a compound is high, the transparent conductive film is easily doped with the Group III element.

A method for making a tandem thin-film photoelectric converter including a transparent electrode layer, at least one amorphous silicon photoelectric conversion unit, at least one crystalline silicon photoelectric conversion unit, and a back electrode layer stacked in that order on a transparent insulating substrate, wherein a step of forming the back electrode layer is preferably carried out using the method for making the transparent conductive film described above, the transparent insulating substrate being used as the substrate. Since the back electrode layer is formed without damaging the photoelectric conversion units, the efficiency of the thin-film photoelectric converter is improved.

A method for making a tandem thin-film photoelectric converter including a transparent electrode layer, at least one amorphous silicon photoelectric conversion unit, at least one crystalline silicon photoelectric conversion unit, and a back electrode layer stacked in that order on a transparent insulating substrate, wherein a step of forming the transparent electrode layer is preferably carried out using the method for making the transparent conductive film described above, the transparent insulating substrate being used as the substrate. Since fine unevenness can be easily provided on the surface of the transparent conductive film, the power generation efficiency is improved by the light trapping effect due to scattering of light.

### [Advantages]

A method for making a transparent conductive film according to the present invention according to claim 1 forms a transparent conductive film containing zinc oxide as a main component on a substrate disposed in the deposition chamber. By using hydrogen as the dilution gas, it is possible to provide a transparent conductive film having excellent characteristics with low cost because hydrogen has high thermal conductivity and is an inexpensive gas.

### Brief Description of the Drawings

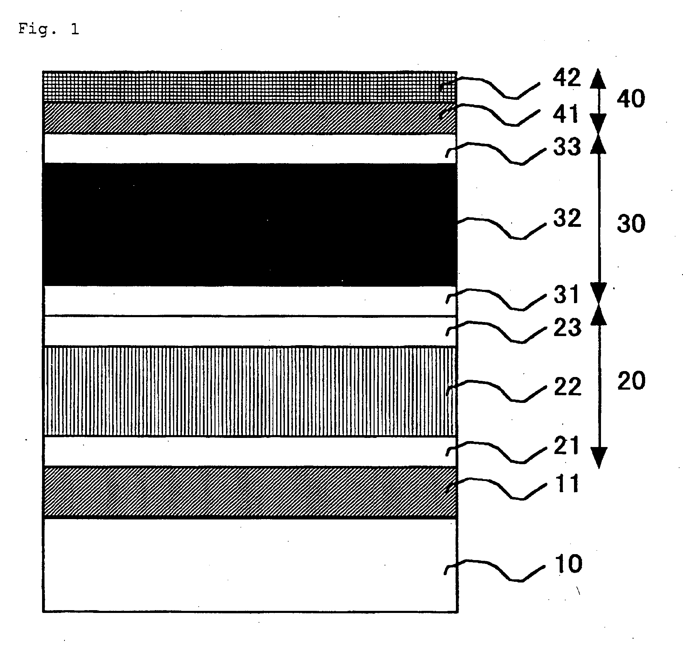

Fig. 1 is a schematic cross-sectional view which shows a lamination structure of an exemplary tandem thin-film photoelectric converter.

### Reference Numerals

- 10: transparent insulating substrate
- 11: transparent electrode layer
- 20: amorphous silicon photoelectric conversion unit
- 21: p-type layer
- 22: i-type layer
- 23: n-type layer
- 30: crystalline silicon photoelectric conversion unit
- 31: p-type layer
- 32: i-type layer
- 33: n-type layer
- 40: back electrode layer
- 41: zinc oxide layer
- 42: Ag layer

### Best Mode for Carrying Out the Invention

The present inventors attempted to form transparent conductive films using N₂ and others as the dilution gases as in the prior art described above. As a result, due to relatively small thermal conductivities of these gases or for other reasons, a long soaking time was required until the surface temperature of the substrate was stabilized. Consequently, the uniformity in temperature distribution in the substrate was poor during deposition, and the in-plane uniformity in the film properties of the resulting transparent conductive films was poor. The present invention has been achieved based on such findings.

In a method for forming a zinc oxide film according to the present invention, desirably, the substrate is maintained at 50°C to 300°C, preferably at 100°C to 200°C.

Any substrate that is not deformed or altered in properties at the temperatures described above may be used. Examples of the material for the substrate include metals, glass plates, and plastics. When a thin-film photoelectric converter is formed on a substrate in which light enters from the substrate side, the substrate is preferably composed of a light-transmissive glass plate or plastic.

The organozinc compound is a divalent organometallic compound containing zinc bound to an organic group. Since the organozinc compound is usually in a liquid state at room temperature and normal pressure, the organozinc compound is vaporized by heating before introduction into the deposition chamber. Alternatively, a dilution gas may be injected into the organozinc compound, and the organozinc compound in an amount corresponding to the vapor pressure may be introduced into the deposition chamber together with the dilution gas.

As the organozinc compound, preferably, a compound represented by R₂Zn (wherein R is an organic group) is used in view of high reactivity with the oxidizing agent. Examples of the organic group include an alky group, an alkenyl group, and an alkynyl group. Among them, the alkyl group is preferable because of its high reactivity and inexpensiveness. In particular, a methyl group or an ethyl group is preferable in view of versatility and ease of procurement of raw materials.

An oxidizing agent is oxygen itself or any substance that has an oxygen atom in its molecule and reacts with an organometallic compound to generate a metal oxide. Oxidizing agents include those which are in a liquid state at room temperature and normal pressure. In such a case, the oxidizing agent is vaporized by heating before introduction into the deposition chamber. Alternatively, a dilution gas may be injected into the oxidizing agent, and the oxidizing agent in an amount corresponding to the vapor pressure may be introduced into the deposition chamber together with the dilution gas. Examples of oxidizing agents include water, oxygen, ozone, alcohols, aldehydes, and ketones.

According to the present invention the oxidizing agent is water because of its high reactivity with the organozinc compound and its good diffusivity in a gaseous state.

As the dilution gas, a dilution gas that is inert against the organozinc compound and the oxidizing agent is used. The dilution gas dilutes the organozinc compound and the oxidizing agent to control their reactivities, and also enhances the diffusivity of the source gas in the deposition chamber to improve the uniformity of deposition. In the present invention, as the dilution gas, use of hydrogen instead of an inert gas, such as argon, helium, or nitrogen, is important in forming a high-quality zinc oxide film.

The film resistivity of the transparent conductive film containing zinc oxide as a main component, which is formed by the method according to the present invention, is controlled by adding a dopant comprising a Group III element into the film. The dopant comprising a Group III element means a hydrogen compound or organic compound of a Group III element. For example, when boron is used as a dopant, diborane is used as the compound comprising the Group III element. Alternatively, an organic borane compound may be used. In particular, trimethylborane or triethylborane is preferable in view of high doping efficiency. When aluminum is used as a dopant, an organoaluminum compound is used as the compound comprising the Group III element. In particular, trimethylaluminum or triethylaluminum is preferable in view of high doping efficiency. Furthermore, gallium may be used as a dopant.

The deposition chamber is provided with a heater for regulating the temperature of the substrate, a gas inlet, an exhaust valve, etc. In order to obtain a uniform film having satisfactory properties, the pressure in the deposition chamber is maintained at 1.3 to 399 Pa (0.01 to 3 Torr), and preferably at 1.3 to 399 Pa (0.1 to 1 Torr). The pressure in the deposition chamber is controlled by the exhaust valve connected to the deposition chamber or by the amount of hydrogen serving as the dilution gas.

Fig. 1 shows an exemplary tandem thin-film photoelectric converter to which the method for making the transparent conductive film according to the present invention is applied. With reference to Fig. 1, the corresponding tandem thin-film photoelectric converter will be described. The tandem thin-film photoelectric converter shown in Fig. 1 is a silicon-based hybrid thin-film solar cell including an amorphous silicon photoelectric conversion unit and a crystalline silicon photoelectric conversion unit, and can be fabricated by the method described below.

First, a transparent electrode layer 11 composed of a transparent conductive film is formed on a transparent insulating substrate 10. The transparent insulating substrate 10 is preferably composed of a light-transmissive glass plate or plastic because it is placed on the light incidence side. As the transparent electrode layer, zinc oxide, tin oxide, or the like can be used. Preferably, a transparent conductive film containing zinc oxide as a main component is used. The reason for this is that fine unevenness having the light trapping effect can be easily provided on the surface of the zinc oxide film even at a low temperature of 200°C or less, and zinc oxide is a material having high plasma durability. Subsequently, an amorphous silicon photoelectric conversion unit 20 is formed on the transparent electrode layer 11 by plasma CVD. The amorphous silicon photoelectric conversion unit 20 includes a p-type layer 21, an i-type layer 22, and an n-type layer 23. The amorphous silicon photoelectric conversion unit 20 is composed of an amorphous silicon-based material that is sensitive to light with a wavelength of about 360 to 800 nm.

Subsequently, a crystalline silicon photoelectric conversion unit 30 is formed on the amorphous silicon photoelectric conversion unit 20 by plasma CVD. The crystalline silicon photoelectric conversion unit 30 includes a p-type layer 31, an i-type layer 32, and an n-type layer 33. The crystalline silicon photoelectric conversion unit 30 is composed of crystalline silicon-based material that is sensitive to light with a wavelength of about 500 to 1,200 nm. By stacking these two units, it is possible to effectively utilize light with a wide range of wavelengths. Furthermore, a back electrode layer 40 is formed on the crystalline silicon photoelectric conversion unit 30. The back electrode layer 40 includes a zinc oxide layer 41 and an Ag layer 42. The zinc oxide layer 41 is formed by sputtering or CVD. From the standpoint of reducing electrical damage to the silicon layer, the zinc oxide layer 41 is preferably formed by CVD. The Ag layer 42 can be formed by sputtering, vapor deposition, or the like.

The resistivity, thickness, transmittance, and haze ratio of the film containing zinc oxide as a main component formed in each example described below were respectively measured using a resistivity meter, an ellipsometer, a spectrophotometer, and a hazemeter. The haze ratio is determined by the following formula: (scattered light transmittance)/(total light transmittance) × 100, and is measured by a method according to JIS K7136.

As specific examples of the embodiment described above, some examples will be described below together with comparative examples.

### (Comparative Example 1)

In Comparative Example 1, as a transparent conductive film, a zinc oxide film was formed on a transparent insulating substrate, and evaluation was performed. First, a glass substrate, i.e., the transparent insulating substrate, was carried in a deposition chamber, and the temperature of the substrate was increased to and maintained at 150°C. A mixed gas of 600 sccm of argon as a dilution gas and 100 sccm of vaporized water was introduced into the deposition chamber, and subsequently, introduction of 50 sccm of vaporized diethylzinc was started. The pressure in the deposition chamber was set at 1 Torr by adjusting the valve. Under such conditions, the zinc oxide film was deposited so as to have a thickness of 60 nm. The thickness was measured using an ellipsometer. The transmittance of the resulting zinc oxide film along with the glass substrate was measured using a spectrophotometer. As a result, the transmittance at a wavelength of 1,000 nm was 89%.

### Supportive Example 1

In Example 1, as a transparent conductive film, a zinc oxide film was formed on a glass substrate as in Comparative Example 1 except that hydrogen was used as the dilution gas instead of argon.

A mixed gas of 1,500 sccm of hydrogen and 100 sccm of vaporized water was first introduced into the deposition chamber, and then 50 sccm of vaporized diethylzinc was introduced into the deposition chamber. The pressure in the deposition chamber was set at 133 Pa (1 Torr) by adjusting the valve. Under such conditions, the zinc oxide film was deposited so as to have a thickness of 60 nm. The transmittance was measured using a spectrophotometer as in Comparative Example 1. As a result, the transmittance at a wavelength of 1,000 nm was 91%. As is evident from comparison of Comparative Example 1 with Supportive Example 1, the transmittance is improved in Supportive Example 1

### (Comparative Example 2)

In Comparative Example 2, as a transparent conductive film, a zinc oxide film was formed on a glass substrate, and evaluation was performed. First, a glass substrate was carried in a deposition chamber, and the temperature of the substrate was increased to and maintained at 150°C. A mixed gas of 700 sccm of argon gas containing diborane that had been diluted to 5,000 ppm with argon and 100 sccm of vaporized water was introduced into the deposition chamber, and subsequently, introduction of 50 sccm of vaporized diethylzinc was started. The pressure in the deposition chamber was set at 133 Pa (1 Torr) by adjusting the valve. Under such conditions, the zinc oxide film was deposited so as to have a thickness of 1.5 µm. The thickness was measured using an ellipsometer. The resistivity, haze ratio, and transmittance of the resulting zinc oxide film were respectively measured using a resistivity meter, a hazemeter, and a spectrophotometer. As a result, the resistivity was 3 × 10⁻³ Ω·cm, the haze ratio was 19%, and the transmittance at a wavelength of 1,000 nm was 76%.

### Supportive Example 2

In Example 2, as a transparent conductive film, a zinc oxide film was formed on a glass substrate and evaluation was performed as in Comparative Example 2 except that hydrogen was used instead of argon.

A mixed gas of 1,500 sccm of argon gas containing diborane that had been diluted to 5,000 ppm with argon and 100 sccm of vaporized water was introduced into the deposition chamber, and subsequently, introduction of 50 sccm of vaporized diethylzinc was started. Furthermore, the pressure in the deposition chamber was set at 133 Pa (1 Torr) by adjusting the valve. Under such conditions, the zinc oxide film was deposited so as to have a thickness of 1.5 µm. As in Comparative Example 2, the resistivity, haze ratio, and transmittance of the resulting zinc oxide film were respectively measured using a resistivity meter, a hazemeter, and a spectrophotometer. As a result, the resistivity was 9 × 10⁻⁴ Ω·cm, the haze ratio was 20%, and the transmittance at a wavelength of 1,000 nm was 81%.

As is evident from comparison of Comparative Example 2 with Supportive Example 2, the resistivity is decreased and the transmittance is improved in Example 2. Although the reasons for this are uncertain, the zinc oxide film with low resistivity and high transmittance is believed to have been obtained because boron serving as the dopant is activated more efficiently and the excessive amount of oxygen present in the grain boundaries is decreased by the deposition in a hydrogen atmosphere compared with the deposition in an argon atmosphere, and for other reasons.

### (Comparative Example 3)

In Comparative Example 3, a tandem thin-film photoelectric converter corresponding to Fig. 1 was fabricated.

First, a transparent electrode layer 11 comprising a transparent conductive film made of tin oxide was formed on a transparent insulating substrate 10. Subsequently, an amorphous silicon photoelectric conversion unit 20 with a thickness of about 300 nm was formed by plasma CVD on the transparent electrode layer 11. The amorphous silicon photoelectric conversion unit 20 included a p-type layer 21, an i-type layer 22, and an n-type layer 23. The thickness of each of the p-type layer 21 and the n-type layer 23 was set at 10 nm.

Subsequently, a crystalline silicon photoelectric conversion unit 30 with a thickness of about 1.4 µm was formed by plasma CVD on the amorphous silicon photoelectric conversion unit 20. The crystalline silicon photoelectric conversion unit 30 included a p-type layer 31, an i-type layer 32, and an n-type layer 33. The thickness of each of the p-type layer 31 and the n-type layer 33 was set at 10 nm.

Furthermore, a back electrode layer 40 was formed on the crystalline silicon photoelectric conversion unit 30. The back electrode layer 40 included a zinc oxide layer 41 and an Ag layer 42. The zinc oxide layer 41 with a thickness of 60 nm was formed under the conditions shown in Comparative Example 1. The Ag layer 42 with a thickness of 200 nm was formed by sputtering on the zinc oxide layer 41.

The tandem thin-film photoelectric converter thus obtained was irradiated with light of AM 1.5 at a light intensity of 100 mW/cm², and the output characteristics at 25°C were measured. The open-circuit voltage was 1.33 V, the short-circuit current density was 11.9 mA/cm², the fill factor was 72.0%, and the conversion efficiency was 11.4%.

### Supportive Example 3

In Example 3, a tandem thin-film solar cell shown in Fig. 1 was fabricated as in Comparative Example 3 except that the zinc oxide layer 41 was deposited under different conditions. The zinc oxide layer 41 was deposited under the same conditions as those shown in Example 1. The output characteristics of the tandem thin-film solar cell thus formed in Supportive Example 3 were measured under the same conditions as those in Comparative Example 3. The open-circuit voltage was 1.35 V, the short-circuit current density was 12.4 mA/cm², the fill factor was 71%, and the conversion efficiency was 11.9%. The performance is improved as compared to Comparison Example 3.

Although the reasons for this are uncertain, it is believed that electrical and optical characteristics of the zinc oxide layer itself are improved and that since the surface of the n-type layer 33 of the crystalline silicon photoelectric conversion unit is exposed to a hydrogen atmosphere, the interface between the n-type layer 33 and the zinc oxide layer 41 is cleaned, and thus the characteristics are improved.

### (Comparative Example 4)

In Comparative Example 4, a tandem thin-film photoelectric converter corresponding to Fig. 1 was fabricated.

First, a transparent electrode layer 11 comprising a zinc oxide film was formed on a transparent insulating substrate 10. The transparent electrode layer 11 was deposited under the same deposition conditions as those in Comparative Example 2.

Subsequently, an amorphous silicon photoelectric conversion unit 20 with a thickness of about 330 nm was formed by plasma CVD on the transparent electrode layer 11. The amorphous silicon photoelectric conversion unit 22 included a p-type layer 22, an i-type layer 22, and an n-type layer 23. The thickness of each of the p-type layer 21 and the n-type layer 22 was set at 10 nm.

Furthermore, a crystalline silicon photoelectric conversion unit 30 with a thickness of about 1.65 µm was formed by plasma CVD on the amorphous silicon photoelectric conversion unit 20. The crystalline silicon photoelectric conversion unit 30 included a p-type layer 31, an i-type layer 32, and an n-type layer 33. The thickness of each of the p-type layer 31 and the n-type layer 33 was set at 10 nm.

Subsequently, a back electrode layer 40 was formed on the crystalline silicon photoelectric conversion unit 30. The back electrode layer 40 included a zinc oxide layer 41 and an Ag layer 42. The zinc oxide layer 441 with a thickness of 60 nm was formed by sputtering. The Ag layer 42 with a thickness of 200 nm was formed by sputtering on the zinc oxide layer 41.

The tandem thin-film photoelectric converter thus obtained was irradiated with light of AM 1.5 at a light intensity of 100 mW/cm², and the output characteristics were measured. The open-circuit voltage was 1.30 V, the short-circuit current density was 12.4 mA/cm², the fill factor was 70.0%, and the conversion efficiency was 11.3%.

### Supportive Example 4

In Example 4, a tandem thin-film solar cell shown in Fig. 1 was fabricated as in Comparative Example 4 except that the zinc oxide layer 11 was deposited under different conditions. The zinc oxide layer 11 was deposited under the same conditions as those shown in Supportive Example 2. The output characteristics of the tandem thin-film solar cell thus formed in Supportive Example 4 were measured under the same conditions as those in Comparative Example 3. The open-circuit voltage was 1.30 V, the short-circuit current density was 12.6 mA/cm², the fill factor was 71%, and the conversion efficiency was 11.6%. The performance is improved as compared to Comparison Example 4.

## Claims

1. A method for making a transparent conductive film comprising introducing an organozinc compound, a dilution gas, and an oxidizing agent into a deposition chamber to form a transparent conductive film containing zinc oxide as a main component on a substrate disposed in the deposition chamber, wherein the dilution gas is hydrogen, wherein the oxidizing agent is water, and
wherein a Group III element-containing compound is introduced into the deposition chamber so that the transparent conductive film containing zinc oxide as the main component doped with a small amount of the Group III element is formed on the substrate.

2. The method for making the transparent conductive film according to Claim 1, wherein the organozinc compound is diethylzinc.

3. The method for making the transparent conductive film according to Claim 1, wherein the Group III element-containing compound is at least one of diborane (B₂H₆) and trimethylaluminum ((CH₃)₃Al).

4. A method for making a tandem thin-film photoelectric converter comprising a transparent electrode layer, at least one amorphous silicon photoelectric conversion unit, at least one crystalline silicon photoelectric conversion unit, and a back electrode layer stacked in that order on a transparent insulating substrate, the method comprising a step of forming the back electrode layer by the method for making the transparent conductive film according to any one of Claims 1 to 3, the transparent insulating substrate being used as the substrate.

5. A method for making a tandem thin-film photoelectric converter comprising a transparent electrode layer, at least one amorphous silicon photoelectric conversion unit, at least one crystalline silicon photoelectric conversion unit, and a back electrode layer stacked in that order on a transparent insulating substrate, the method comprising a step of forming the transparent electrode layer by the method for making the transparent conductive film according to any one of Claims 1 to 3, the transparent insulating substrate being used as the substrate.

## Patentansprüche

1. Verfahren zur Herstellung eines transparenten leitfähigen Films durch Einleiten einer zinkorganischen Verbindung, eines Verdünnungsgases und eines Oxidationsmittels in eine Abscheidungskammer zur Bildung eines transparenten leitfähigen Films mit Zinkoxid als einem Hauptbestandteil auf einem Substrat in der Abscheidungskammer, wobei das Verdünnungsgas Wasserstoff ist,
das Oxidationsmittel Wasser ist und
eine ein Element der Gruppe III enthaltende Verbindung in die Abscheidungskammer eingeleitet wird, so dass der transparente leitfähige Film, der Zinkoxid als den Hauptbestandteil enthält, das mit einer kleinen Menge des Elements der Gruppe III dotiert ist, auf dem Substrat gebildet wird.

2. Verfahren zur Herstellung des transparenten leitfähigen Films nach Anspruch 1, wobei die zinkorganische Verbindung Diethylzink ist.

3. Verfahren zur Herstellung des transparenten leitfähigen Films nach Anspruch 1, wobei die das Element der Gruppe III enthaltende Verbindung mindestens eine von Diboran (B₂H₆) und Trimethylaluminium ((CH₃) ₃Al) ist.

4. Verfahren zur Herstellung eines photoelektrischen Tandem-Dünnschicht-Umwandlers umfassend eine transparente Elektrodenschicht, mindestens eine photoelektrische Umwandlungseinheit auf Basis von amorphem Silicium, mindestens eine photoelektrische Umwandlungseinheit auf Basis von kristallinem Silicium und eine Rückelektrodenschicht, die in dieser Reihenfolge übereinander auf einem transparenten, isolierenden Substrat angeordnet sind, wobei das Verfahren aufweist:
einen Schritt zur Bildung der Rückelektrodenschicht gemäß dem Verfahren zur Herstellung des transparenten leitfähigen Films nach einem der Ansprüche 1 bis 3, wobei das transparente isolierende Substrat als das Substrat verwendet wird.

5. Verfahren zur Herstellung eines photoelektrischen Tandem-Dünnschicht-Umwandlers umfassend eine transparente Elektrodenschicht, mindestens eine photoelektrische Umwandlungseinheit auf Basis von amorphem Silicium, mindestens eine photoelektrische Umwandlungseinheit auf Basis von kristallinem Silicium und eine Rückelektrodenschicht, die in dieser Reihenfolge übereinander auf einem transparenten, isolierenden Substrat angeordnet sind, wobei das Verfahren aufweist:
einen Schritt zur Bildung der transparenten Elektrodenschicht gemäß dem Verfahren zur Herstellung des transparenten leitfähigen Films nach einem der Ansprüche 1 bis 3, wobei das transparente isolierende Substrat als das Substrat verwendet wird.

## Revendications

1. Procédé de fabrication d'une pellicule conductrice transparente comprenant l'introduction d'un composé organique de zinc, d'un gaz de dilution et d'un agent oxydant dans une chambre de dépôt pour former une pellicule conductrice transparente contenant de l'oxyde de zinc en tant que composant principal sur un substrat disposé dans la chambre de dépôt, le gaz de dilution étant de l'hydrogène, l'agent oxydant étant de l'eau, et un composé contenant un élément du groupe 3 étant introduit dans la chambre de dépôt de manière à former sur le substrat une pellicule conductrice transparente contenant de l'oxyde de zinc en tant que composant principal dopé avec une faible teneur de l'élément du groupe 3.

2. Procédé de fabrication de la pellicule conductrice transparente selon la revendication 1, où le composé organique de zinc est le diéthylzinc.

3. Procédé de fabrication de la pellicule conductrice transparente selon la revendication 1, où le composé contenant un élément du groupe 3 est le diborane (B₂H₆) et/ou le triméthylaluminum ((CH₃) ₃Al).

4. Procédé de fabrication d'un convertisseur photoélectrique tandem à couche mince comprenant une couche d'électrode transparente, au moins une unité de conversion photoélectrique au silicium amorphe, au moins une unité de conversion photoélectrique au silicium cristallin et une couche de contre-électrode empilées dans cet ordre sur un substrat isolant transparent, ledit procédé comprenant une étape de formation de la couche de contre-électrode au moyen du procédé de fabrication de la pellicule conductrice transparente selon l'une des revendications 1 à 3, le substrat isolant transparent étant utilisé comme substrat.

5. Procédé de fabrication d'un convertisseur photoélectrique tandem à couche mince comprenant une couche d'électrode transparente, au moins une unité de conversion photoélectrique au silicium amorphe, au moins une unité de conversion photoélectrique au silicium cristallin et une couche de contre-électrode empilées dans cet ordre sur un substrat isolant transparent, ledit procédé comprenant une étape de formation de la couche d'électrode transparente au moyen du procédé de fabrication de la pellicule conductrice transparente selon l'une des revendications 1 à 3, le substrat isolant transparent étant utilisé comme substrat.
